(19) Europäisches Patentamt / European Patent Office / Office européen des brevets

(11) **EP 2 952 972 B1**

(12) **FASCICULE DE BREVET EUROPEEN**

(45) Date de publication et mention
de la délivrance du brevet:
**25.01.2017 Bulletin 2017/04**

(51) Int Cl.:
***B81C 1/00*** *(2006.01)*  ***G04B 17/06*** *(2006.01)*
***G04B 17/22*** *(2006.01)*

(21) Numéro de dépôt: **14171012.9**

(22) Date de dépôt: **03.06.2014**

(54) **Procédé de fabrication d'un spiral compensateur composite**

Herstellungsverfahren einer Ausgleichsspiralfeder aus Verbundmaterial

Method for manufacturing a composite compensator spiral

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**09.12.2015 Bulletin 2015/50**

(73) Titulaire: **The Swatch Group Research and
Development Ltd.
2074 Marin (CH)**

(72) Inventeur: **Hessler, Thierry
2024 St-Aubin (CH)**

(74) Mandataire: **Goulette, Ludivine et al
ICB
Ingénieurs Conseils en Brevets SA
Faubourg de l'Hôpital 3
2001 Neuchâtel (CH)**

(56) Documents cités:
**EP-A1- 0 732 635   EP-A1- 1 422 436
EP-A1- 1 791 039   CH-B1- 706 252**

**Description**

Domaine de l'invention

L'invention se rapporte à un procédé de fabrication d'un spiral compensateur composite et notamment un tel spiral destiné à coopérer avec un balancier afin de former un résonateur thermo-compensé, c'est-à-dire dont la fréquence est très peu ou pas sensible aux variations de température.

Arrière-plan de l'invention

Le document EP 1 422 436 divulgue un spiral formé en silicium et recouvert de dioxyde de silicium afin de rendre le coefficient thermique sensiblement nul autour des températures de procédure COSC, c'est-à-dire entre +8 et +38 °C. L'oxyde de silicium est généralement obtenu par oxydation de l'âme en silicium ce qui rend possible la fabrication industrielle des spiraux compensateurs.

Toutefois, d'autres couples de matériaux sont envisageables mais sont plus difficiles à solidariser et donc à produire.

Résumé de l'invention

Le but de la présente invention est de pallier tout ou partie les inconvénients cités précédemment en proposant un procédé alternatif de fabrication de spiraux compensateurs composites qui permette une plus grande possibilité de matériaux qu'uniquement du silicium avec du dioxyde de silicium.

A cet effet, selon un premier mode de réalisation, l'invention se rapporte à un procédé de fabrication d'un spiral compensateur composite comportant les étapes suivantes :

a) se munir d'une première plaquette en un premier matériau ;
b) se munir d'au moins une deuxième plaquette en au moins un deuxième matériau dont les variations du module d'Young en fonction de la température sont de signe opposé à celles du premier matériau ;
c) solidariser la première plaquette à ladite au moins une deuxième plaquette afin de former un substrat ;
d) graver dans le substrat un motif traversant afin de former un spiral compensateur composite comportant une première épaisseur dudit premier matériau et au moins une deuxième épaisseur dudit au moins deuxième matériau ;
e) libérer du substrat le spiral compensateur composite.

De plus, selon un deuxième mode de réalisation, l'invention se rapporte à un procédé de fabrication d'un spiral compensateur composite comportant les étapes suivantes :

a) se munir d'une première plaquette en un premier matériau ;
b) se munir d'au moins une deuxième plaquette en au moins un deuxième matériau dont les variations du module d'Young en fonction de la température sont de signe opposé à celles du premier matériau ;
d') graver des motifs traversants identiques dans chacune des plaquettes ;
c') solidariser la première plaquette à ladite au moins une deuxième plaquette pour réaliser un substrat et, par superposition desdits même motifs, former un spiral compensateur composite comportant une première épaisseur dudit premier matériau et au moins une deuxième épaisseur dudit au moins deuxième matériau ;
e) libérer du substrat le spiral compensateur composite.

Enfin, selon un troisième mode de réalisation, l'invention se rapporte à un procédé de fabrication d'un spiral compensateur composite comportant les étapes suivantes :

a) se munir d'une première plaquette en un premier matériau ;
b) se munir d'au moins une deuxième plaquette en au moins un deuxième matériau dont les variations du module d'Young en fonction de la température sont de signe opposé à celles du premier matériau ;
f) graver des motifs identiques dans chacune des plaquettes sur une partie seulement de l'épaisseur ;
g) solidariser la première plaquette à ladite au moins une deuxième plaquette pour réaliser un substrat par superposition desdits même motifs ;
f') graver lesdits motifs identiques dans le reste du substrat afin de former un spiral compensateur composite comportant une première épaisseur dudit premier matériau et au moins une deuxième épaisseur dudit au moins deuxième matériau ;
e) libérer du substrat le spiral compensateur composite.

Avantageusement selon l'invention, une grande variété de matériaux peut donc être utilisée pour former des spiraux compensateurs composites de manière industrielle. Suivant les matériaux utilisés, au moins un des trois modes de réalisation est utilisable pour fabriquer un spiral compensateur composite comportant une première épaisseur $E_1$ dudit premier matériau et au moins une deuxième épaisseur $E_2$ dudit au moins deuxième matériau.

Conformément à d'autres variantes avantageuses de l'invention :

-   le premier matériau et/ou ledit au moins un deuxième matériau est formé à base de silicium et comporte du silicium monocristallin, du silicium monocristallin dopé, du silicium polycristallin, du silicium polycristallin dopé, du silicium poreux, de l'oxyde de silicium, du quartz, de la silice, du nitrure de silicium ou du carbure de silicium ;
-   le premier matériau et/ou ledit au moins un deuxième matériau est formé à base de céramique et comporte du verre photostructurable, du borosilicate, de l'aluminosilicate, du verre de quartz, du zérodur, du corindon monocristallin, du corindon polycristallin, de l'alumine, de l'oxyde d'aluminium, du nitrure d'aluminium, du rubis monocristallin, du rubis polycristallin, de l'oxyde de zirconium, de l'oxyde de titane, du nitrure de titane, du carbure de titane, du nitrure de tungstène, du carbure de tungstène, du nitrure de bore ou du carbure de bore ;

-   le premier matériau et/ou ledit au moins un deuxième matériau est formé à base de métal et comporte un alliage de fer, un alliage de cuivre, du nickel ou un de ses alliages, du titane ou un de ses alliages, de l'or ou un de ses alliages, de l'argent ou un de ses alliages, du platine ou un de ses alliages, du ruthénium ou un de ses alliages, du rhodium ou un de ses alliages ou du palladium ou un de ses alliages ;
-   plusieurs spiraux compensateurs composites sont réalisés sur le même substrat.

Description sommaire des dessins

D'autres particularités et avantages ressortiront clairement de la description qui en est faite ci-après, à titre indicatif et nullement limitatif, en référence aux dessins annexés, dans lesquels :

-   les figures 1 à 3 sont des vues d'étapes d'un premier mode de réalisation de l'invention en utilisant deux plaquettes ;
-   les figures 4 à 6 sont des vues d'étapes d'un deuxième mode de réalisation de l'invention en utilisant deux plaquettes ;
-   les figures 7 à 10 sont des vues d'étapes d'un troisième mode de réalisation de l'invention en utilisant deux plaquettes ;
-   la figure 11 est une vue en perspective d'un spiral compensateur composite selon l'un des trois modes de réalisation de l'invention en utilisant deux plaquettes ;
-   les figures 12 et 13 sont des vues d'étapes d'une alternative du premier mode de réalisation de l'invention en utilisant plus de deux plaquettes ;
-   les figures 14 à 17 sont des vues d'étapes d'une alternative des deuxième et troisième modes de réalisation de l'invention en utilisant plus de deux plaquettes ;
-   la figure 18 est une vue en perspective d'un spiral compensateur composite d'une alternative d'un des trois modes de réalisation de l'invention en utilisant plus de deux plaquettes.

Description détaillée des modes de réalisation préférés

Comme expliqué ci-dessus, l'invention se rapporte à un procédé de fabrication d'un spiral compensateur composite destiné à former un résonateur thermo-compensé du type balancier-spiral.

A titre de définition, la variation relative de la fréquence d'un résonateur suit la relation suivante :

$$\frac{\Delta f}{f_0} = A + \alpha \cdot (T - T_0) + \beta \cdot (T - T_0)^2 + \gamma \cdot (T - T_0)^3$$

où :

-   $\dfrac{\Delta f}{f_0}$ est la variation relative de fréquence (ppm ou $10^{-6}$) ;
-   A une constante qui dépend du point de référence (ppm) ;
-   $T_0$ la température de référence (°C) ;
-   $\alpha$ le coefficient thermique du premier ordre (ppm.°C$^{-1}$) ;
-   $\beta$ le coefficient thermique du deuxième ordre (ppm. °C$^{-2}$) ;
-   $\gamma$ le coefficient thermique du troisième ordre (ppm. °C$^{-3}$).

3

**EP 2 952 972 B1**

De plus, le coefficient thermoélastique *(CTE)* représente la variation relative du module d'Young en fonction de la température. Le coefficient thermique, c'est-à-dire la variation relative de la fréquence du résonateur en fonction de la température, dépend du coefficient thermoélastique du corps du résonateur et des coefficients de dilatation du corps. De plus, le coefficient thermique prend également en compte les coefficients propres au balancier (formant un volant d'inertie) pour un résonateur balancier - spiral. Les oscillations de tout résonateur destiné à une base de temps ou de fréquence devant être entretenues, le coefficient thermique comprend également une contribution éventuelle du système d'entretien tel qu'un système d'échappement.

Le paramètre le plus important est donc le coefficient thermoélastique *(CTE)* qu'il ne faut pas confondre avec l'abréviation anglaise CTE pour « Constant of Thermal Expansion » qui concerne le coefficient de dilatation.

L'invention a pour but de pouvoir fabriquer une grande variété de spiraux compensateurs composites comportant au moins deux matériaux solidarisés dont les variations du module d'Young en fonction de la température *(CTE)* sont de signe opposé.

De plus, lesdits au moins deux matériaux peuvent également comporter, de manière optionnelle, un matériau intermédiaire destiné à favoriser la solidarisation entre deux matériaux difficiles à attacher. Ainsi, suivant la technique de solidarisation choisie, ce matériau intermédiaire peut être assimilé à une brasure destinée à attacher deux matériaux par adhérence conjointe sur le matériau intermédiaire, ou former une couche destinée à induire un échauffement suffisamment intense pour générer la fusion des deux matériaux. Bien entendu, en cas d'utilisation d'un tel matériau optionnel intermédiaire, ce dernier doit être également pris en compte pour la compensation globale du coefficient thermique de l'oscillateur.

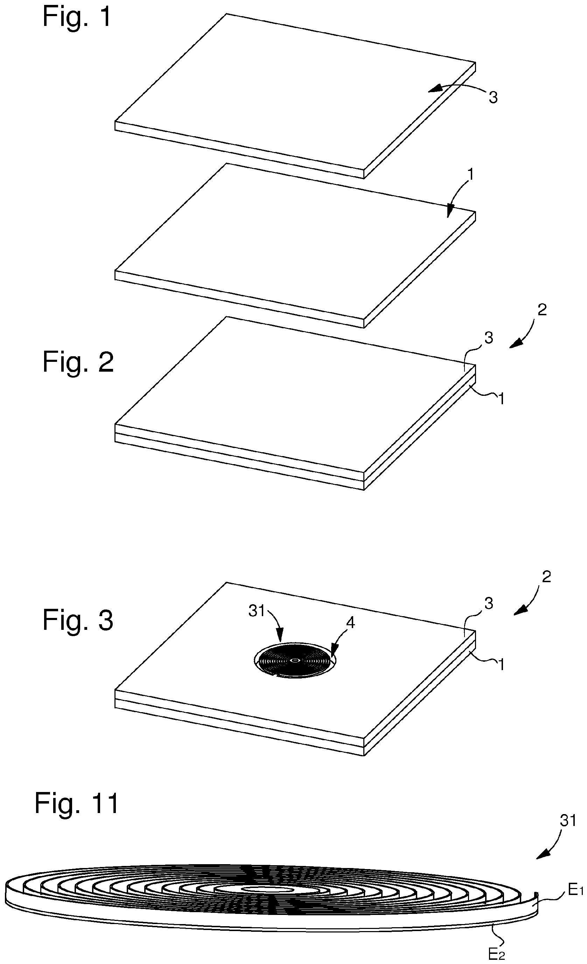

Selon un premier mode de réalisation de l'invention illustré aux figures 1 à 3, le procédé de fabrication comporte une première étape a) destinée à se munir d'une première plaquette 1 en un premier matériau. Une deuxième étape b) est destinée à se munir d'au moins une deuxième plaquette 3 en au moins un deuxième matériau dont les variations du module d'Young en fonction de la température *(CTE)* sont de signe opposé à celles *(CTE)* du premier matériau.

Comme visible à la figure 2, une troisième étape c) est destinée à solidariser la première plaquette 1 à ladite au moins une deuxième plaquette 3 afin de former un substrat 2. Suivant les matériaux utilisés, plusieurs solidarisations sont possibles. A titre nullement limitatif, on peut citer le soudage direct des surfaces par rayonnement électromagnétique au moyen d'un laser comme, par exemple, expliqué dans le document EP 1 436 830 incorporé par référence dans la présente description. Il est également parfaitement envisageable de recourir à une solidarisation par champ électrique (anodic bonding), une solidarisation par fusion (fusion bonding), une solidarisation par thermocompression (thermocompression bonding), une solidarisation par refusion (reflow bonding), une solidarisation eutectique (eutectic bonding), une solidarisation par ondes vibratoires (ultrasonic bonding) ou une solidarisation combinant chauffage, ondes vibratoires et compression (thermosonic bonding).

Le procédé selon le premier mode de réalisation se poursuit avec une quatrième étape d) destinée à graver dans le substrat un motif 4 traversant afin de former un spiral compensateur composite 31 comportant une première épaisseur $E_1$ dudit premier matériau et au moins une deuxième épaisseur $E_2$ dudit au moins deuxième matériau. Suivant les matériaux utilisés, plusieurs gravages sont possibles. A titre nullement limitatif, on peut citer un gravage sec comme un gravage ionique réactif profond (DRIE), un gravage laser ou un gravage par plasma. Il est également parfaitement envisageable de recourir à un gravage humide comme un gravage chimique. Enfin, une photostructuration mêlant une photolithographie d'une résine suivie d'un gravage sec ou humide peut également être réalisée.

Enfin, le procédé comporte une étape finale e) destinée à libérer du substrat 2 le spiral compensateur composite 31. Avantageusement selon l'invention, une grande variété de matériaux peut donc être utilisée pour former des spiraux compensateurs composites de manière industrielle. Comme illustré à la figure 11, le spiral compensateur composite 31 comporte une première épaisseur $E_1$ dudit premier matériau et au moins une deuxième épaisseur $E_2$ dudit au moins deuxième matériau.

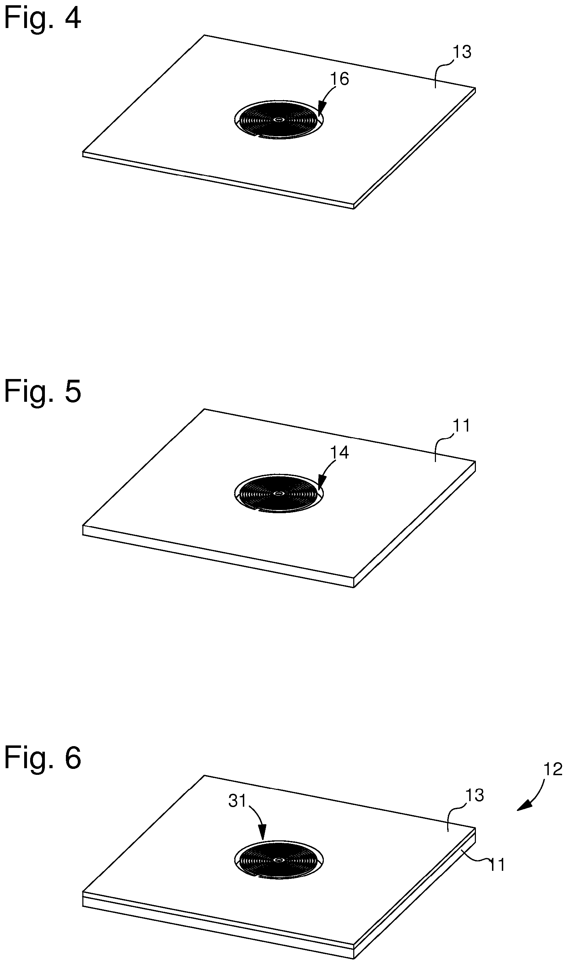

Selon un deuxième mode de réalisation de l'invention illustré aux figures 4 à 6, le procédé de fabrication comporte une première étape a) destinée à se munir d'une première plaquette 11 en un premier matériau. Une deuxième étape b) est destinée à se munir d'au moins une deuxième plaquette 13 en au moins un deuxième matériau dont les variations du module d'Young en fonction de la température *(CTE)* sont de signe opposé à celles *(CTE)* du premier matériau.

Comme visible aux figures 4 et 5, une troisième étape d') est destinée à graver des motifs traversants identiques 14, 16, dans chacune des plaquettes 11, 13. Suivant les matériaux utilisés, plusieurs gravages sont possibles. A titre nullement limitatif, on peut citer un gravage sec comme un gravage ionique réactif profond (DRIE), un gravage laser ou un gravage par plasma. Il est également parfaitement envisageable de recourir à un gravage humide comme un gravage chimique. Enfin, une photostructuration mêlant une photolithographie d'une résine suivie d'un gravage sec ou humide peut également être réalisée.

Le procédé selon le deuxième mode de réalisation se poursuit avec une quatrième étape c') destinée à solidariser la première plaquette 11 à ladite au moins une deuxième plaquette 13 pour réaliser un substrat 12 et, par superposition desdits même motifs 14, 16, former un spiral composite 31 comportant une première épaisseur $E_1$ dudit

**4**

premier matériau et au moins une deuxième épaisseur $E_2$ dudit au moins deuxième matériau.

Suivant les matériaux utilisés, plusieurs solidarisations sont possibles. A titre nullement limitatif, on peut citer le soudage direct des surfaces par rayonnement électromagnétique au moyen d'un laser comme, par exemple, expliqué dans le document EP 1 436 830 incorporé par référence dans la présente description. Il est également parfaitement envisageable de recourir à une solidarisation par champ électrique (anodic bonding), une solidarisation par fusion (fusion bonding), une solidarisation par thermocompression (thermocompression bonding), une solidarisation par refusion (reflow bonding), une solidarisation eutectique (eutectic bonding), une solidarisation par ondes vibratoires (ultrasonic bonding) ou une solidarisation combinant chauffage, ondes vibratoires et compression (thermosonic bonding).

Enfin, le procédé comporte une étape finale e) destinée à libérer du substrat 12 le spiral compensateur composite 31. Avantageusement selon l'invention, une grande variété de matériaux peut donc être utilisée pour former des spiraux compensateurs composites de manière industrielle. Comme illustré à la figure 11, le spiral compensateur composite 31 comporte une première épaisseur $E_1$ dudit premier matériau et au moins une deuxième épaisseur $E_2$ dudit au moins deuxième matériau.

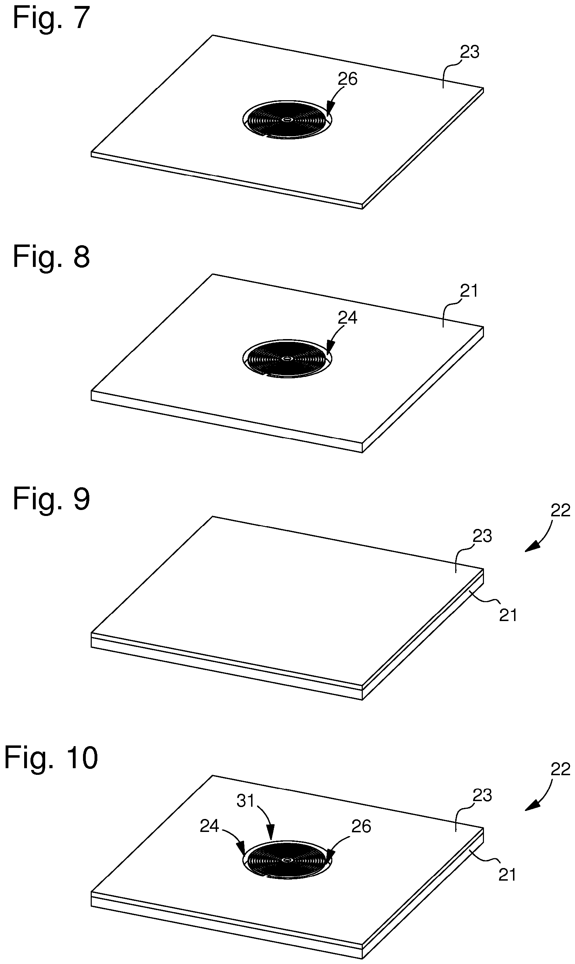

Selon un troisième mode de réalisation de l'invention illustré aux figures 7 à 10, le procédé de fabrication comporte une première étape a) destinée à se munir d'une première plaquette 21 en un premier matériau. Une deuxième étape b) est destinée à se munir d'au moins une deuxième plaquette 23 en au moins un deuxième matériau dont les variations du module d'Young en fonction de la température *(CTE)* sont de signe opposé à celles *(CTE)* du premier matériau.

Comme visible aux figures 7 et 8, une troisième étape f) est destinée à graver des motifs identiques 24, 26 dans chacune des plaquettes 21, 23 sur une partie seulement de l'épaisseur de chaque plaquette 21, 23. A titre nullement limitatif, on peut citer un gravage sec comme un gravage ionique réactif profond (DRIE), un gravage laser ou un gravage par plasma. Il est également parfaitement envisageable de recourir à un gravage humide comme un gravage chimique. Enfin, une photostructuration mêlant une photolithographie d'une résine suivie d'un gravage sec ou humide peut également être réalisée.

Le procédé selon le troisième mode de réalisation se poursuit avec une quatrième étape g) destinée à solidariser la première plaquette 21 à ladite au moins une deuxième plaquette 23 pour réaliser un substrat 22 par superposition desdits même motifs comme visible à la figure 9. Suivant les matériaux utilisés, plusieurs solidarisations sont possibles. A titre nullement limitatif, on peut citer le soudage direct des surfaces par rayonnement électromagnétique au moyen d'un laser comme, par exemple, expliqué dans le document EP 1 436 830 incorporé par référence dans la présente description. Il est également parfaitement envisageable de recourir à une solidarisation par champ électrique (anodic bonding), une solidarisation par fusion (fusion bonding), une solidarisation par thermocompression (thermocompression bonding), une solidarisation par refusion (reflow bonding), une solidarisation eutectique (eutectic bonding), une solidarisation par ondes vibratoires (ultrasonic bonding) ou une solidarisation combinant chauffage, ondes vibratoires et compression (thermosonic bonding).

Le procédé selon le troisième mode de réalisation continue avec une cinquième étape f') destinée à graver lesdits motifs identiques 24, 26 dans le reste du substrat 22 afin de former un spiral compensateur composite 31 comportant une première épaisseur $E_1$ dudit premier matériau et au moins une deuxième épaisseur $E_2$ dudit au moins deuxième matériau. L'étape f') peut être réalisé avec les mêmes techniques citées pour l'étape f) ci-dessus.

Enfin, le procédé comporte une étape finale e) destinée à libérer du substrat 22 le spiral compensateur composite 31. Avantageusement selon l'invention, une grande variété de matériaux peut donc être utilisée pour former des spiraux compensateurs composites de manière industrielle. Ce troisième mode de réalisation peut être particulièrement utile lorsque les valeurs de dilatation entre les deux corps rendent habituellement difficile leur assemblage. Comme illustré à la figure 11, le spiral compensateur composite 31 comporte une première épaisseur $E_1$ dudit premier matériau et au moins une deuxième épaisseur $E_2$ dudit au moins deuxième matériau.

Avantageusement selon l'invention, suivant les matériaux utilisés, au moins un des trois modes de réalisation est utilisable pour fabriquer un spiral compensateur composite 31 comportant une première épaisseur $E_1$ dudit premier matériau et au moins une deuxième épaisseur $E_2$ dudit au moins deuxième matériau. On comprend également que plusieurs spiraux compensateurs composites 31 peuvent être réalisés sur le même substrat 2, 12, 22, chaque spiral compensateur composite pouvant être réalisé selon le même motif 4, 14, 16, 24, 26 ou selon des motifs distincts.

Préférentiellement selon l'invention, le premier matériau et/ou ledit au moins un deuxième matériau est formé à base de silicium ou à base de céramique. Ainsi, quand le premier matériau et/ou ledit au moins un deuxième matériau est à base de silicium, il(s) comporte(nt), de manière préférée, du silicium monocristallin, du silicium monocristallin dopé, du silicium polycristallin, du silicium polycristallin dopé, du silicium poreux, de l'oxyde de silicium, du quartz, de la silice, du nitrure de silicium ou du carbure de silicium.

Alors que, quand le premier matériau et/ou ledit au moins un deuxième matériau est à base de céramique, il(s) comporte(nt), de manière préférée, du verre photostructurable, du borosilicate, de l'aluminosilicate, du verre de quartz, du zérodur, du corindon monocristallin, du corindon polycristallin, de l'alumine, de l'oxyde d'aluminium, du nitrure d'aluminium, du rubis monocristallin, du rubis polycristallin, de l'oxyde de zirconium, de l'oxyde de titane, du nitrure de titane, du carbure de titane, du nitrure de tungstène, du carbure de tungstène, du nitrure de bore ou du carbure de bore.

Enfin, quand le premier matériau et/ou ledit au moins un deuxième matériau est à base de métal, il(s) comporte(nt), de manière préférée, un alliage de fer comme de l'acier 15P, 20AP ou 316L, un alliage de cuivre comme du laiton, un alliage de nickel comme du maillechort, du titane ou un de ses alliages, de l'or ou un de ses alliages, de l'argent ou un de ses alliages, du platine ou un de ses alliages, du ruthénium ou un de ses alliages, du rhodium ou un de ses alliages ou du palladium ou un de ses alliages.

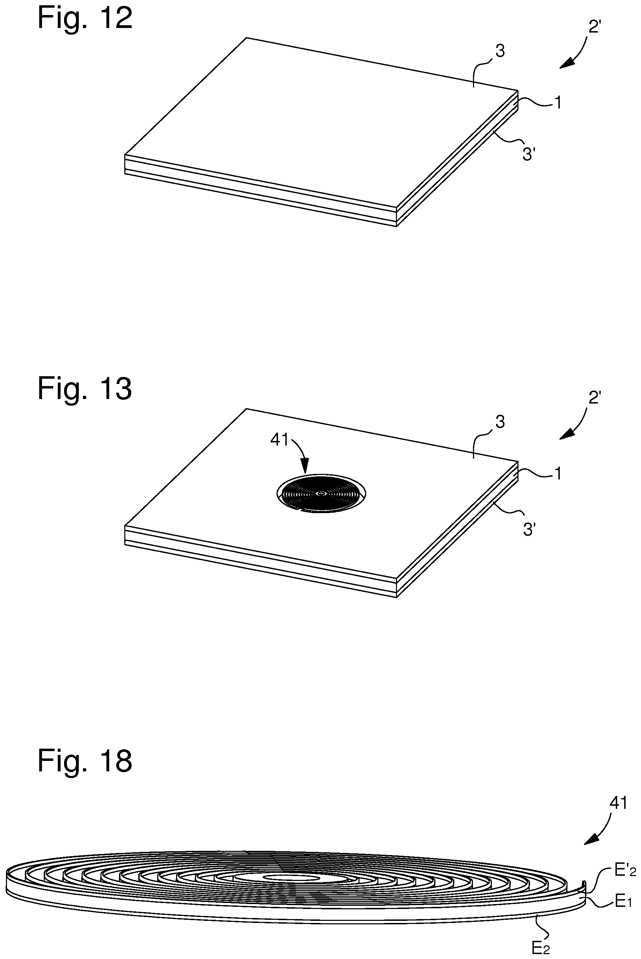

Selon une alternative du premier mode de réalisation illustrée aux figures 12 et 13, l'étape b) peut consister à former plusieurs deuxièmes plaquettes 3, 3' formé à partir du même matériau ou de plusieurs matériaux différents. Les figures illustrent deux plaquettes toutefois, un plus grand nombre de deuxièmes plaquettes peut être prévu.

Dans cette alternative du premier mode de réalisation, on comprend donc qu'on obtient lors de l'étape c) un substrat 2' avec trois plaquettes 3, 1, 3' solidarisées comme illustré à la figure 12. Comme visible à la figure 13, l'étape d) de gravage permet alors de former un spiral compensateur composite 41 comportant une première épaisseur $E_1$ dudit premier matériau et deux deuxièmes épaisseurs $E_2$, $E'_2$ formées à partir du même matériau ou de plusieurs matériaux différents. Un tel spiral compensateur composite 41 est représenté à la figure 18.

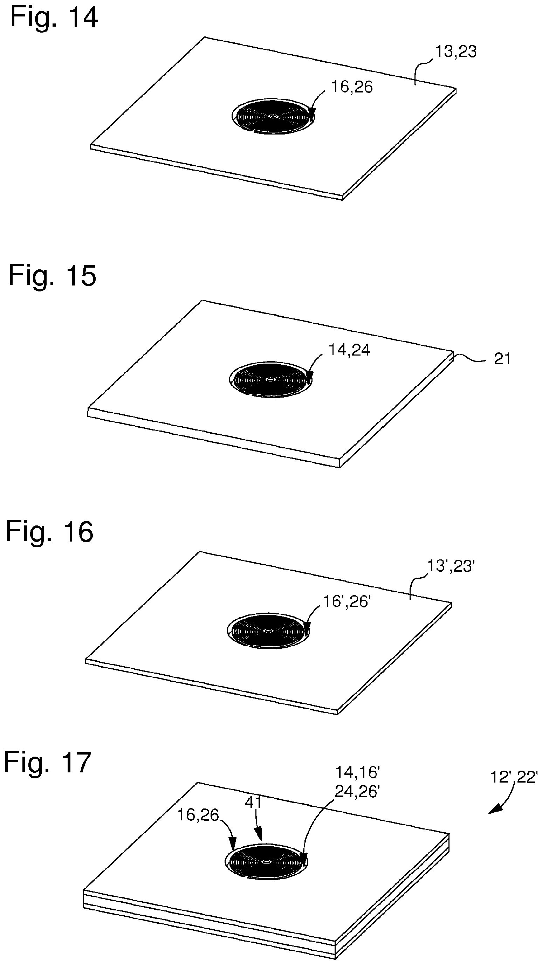

Selon une alternative des deuxième et troisième modes de réalisation illustrée aux figures 14 à 17, l'étape b) peut consister à former plusieurs deuxièmes plaquettes 13, 13', 23, 23' formé à partir du même matériau ou de plusieurs matériaux différents. Les figures illustrent deux plaquettes toutefois, un plus grand nombre de deuxièmes plaquettes peut être prévu.

Dans cette alternative des deuxième et troisième modes de réalisation, on comprend donc qu'on obtient lors de l'étape c') ou g) un substrat 12', 22' avec trois plaquettes 13, 11, 13', 23, 21, 23', solidarisées. Comme visible à la figure 13, l'étape d'), f) ou f') de gravage permet alors de former un spiral compensateur composite 41 comportant une première épaisseur $E_1$ dudit premier matériau et deux deuxièmes épaisseurs $E_2$, $E'_2$ formées à partir du même matériau ou de plusieurs matériaux différents. Un tel spiral compensateur composite 41 est représenté à la figure 18.

Bien entendu, la présente invention ne se limite pas à l'exemple illustré mais est susceptible de diverses variantes et modifications qui apparaîtront à l'homme de l'art. En particulier, d'autres applications pour un résonateur sont réalisables pour un homme du métier sans difficultés excessives à partir de l'enseignement ci-dessus. A titre d'exemple, un diapason ou plus généralement un résonateur du type MEMS (abréviation provenant des termes anglais « Micro Electro-Mechanical System ») pourraient être formés à la place d'un spiral compensateur composite.

Il est également envisageable de recourir à des méthodes de solidarisation alternatives telles que le collage ou le brasage, et/ou des méthodes de gravage alternatives telles que l'usinage mécanique, la découpe par jet d'eau ou une découpe combinant le jet d'eau et le laser.

## Revendications

**1.** Procédé de fabrication d'un spiral compensateur composite (31, 41) comportant les étapes suivantes :

 a) se munir d'une première plaquette (1) en un premier matériau ;
 b) se munir d'au moins une deuxième plaquette (3, 3') en au moins un deuxième matériau dont les variations du module d'Young en fonction de la température *(CTE)* sont de signe opposé à celles *(CTE)* du premier matériau ;
 c) solidariser la première plaquette (1) à ladite au moins une deuxième plaquette (3, 3') afin de former un substrat (2, 2') ;
 d) graver dans le substrat (2) un motif traversant (4) afin de former un spiral compensateur composite (31, 41) comportant une première épaisseur $(E_1)$ dudit premier matériau et au moins une deuxième épaisseur $(E_2, E'_2)$ dudit au moins deuxième matériau ;
 e) libérer du substrat (2, 2') le spiral compensateur composite (31, 41).

**2.** Procédé de fabrication d'un spiral compensateur composite (31, 41) comportant les étapes suivantes :

 a) se munir d'une première plaquette (11) en un premier matériau ;
 b) se munir d'au moins une deuxième plaquette (13, 13') en au moins un deuxième matériau dont les variations du module d'Young en fonction de la température *(CTE)* sont de signe opposé à celles *(CTE)* du premier matériau ;
 d') graver des motifs traversants identiques (14, 16, 16') dans chacune des plaquettes (13, 11, 13') ;
 c') solidariser la première plaquette (11) à ladite au moins une deuxième plaquette (13, 13') pour réaliser un substrat (12, 12') et, par superposition desdits même motifs (14, 16, 16'), former un spiral compensateur composite (31, 41) comportant une première épaisseur $(E_1)$ dudit premier matériau et au moins une deuxième

épaisseur (E$_2$, E'$_2$) dudit au moins deuxième matériau ;

e) libérer du substrat (12, 12') le spiral compensateur composite (31, 41).

3. Procédé de fabrication d'un spiral compensateur composite (31, 41) comportant les étapes suivantes :

a) se munir d'une première plaquette (21) en un premier matériau ;

b) se munir d'au moins une deuxième plaquette (23, 23') en au moins un deuxième matériau dont les variations du module d'Young en fonction de la température *(CTE)* sont de signe opposé à celles *(CTE)* du premier matériau ;

f) graver des motifs identiques (24, 26, 26') dans chacune des plaquettes (23, 21, 23') sur une partie seulement de l'épaisseur ;

g) solidariser la première plaquette (21) à ladite au moins une deuxième plaquette (23, 23') pour réaliser un substrat (22, 22') par superposition desdits même motifs (24, 26, 26') ;

f') graver lesdits motifs identiques (24, 26, 26') dans le reste du substrat (22) afin de former un spiral compensateur composite (31, 41) comportant une première épaisseur (E$_1$) dudit premier matériau et au moins une deuxième épaisseur (E$_2$, E'$_2$) dudit au moins deuxième matériau ;

e) libérer du substrat (22, 22') le spiral compensateur composite (31, 41).

4. Procédé selon l'une des revendications précédentes, **caractérisé en ce que** le premier matériau et/ou ledit au moins un deuxième matériau est formé à base de silicium.

5. Procédé selon la revendication précédente, **caractérisé en ce que** le premier matériau et/ou ledit au moins un deuxième matériau à base de silicium comporte du silicium monocristallin, du silicium monocristallin dopé, du silicium polycristallin, du silicium polycristallin dopé, du silicium poreux, de l'oxyde de silicium, du quartz, de la silice, du nitrure de silicium ou du carbure de silicium.

6. Procédé selon l'une des revendications précédentes, **caractérisé en ce que** le premier matériau et/ou ledit au moins un deuxième matériau est formé à base de céramique.

7. Procédé selon la revendication précédente, **caractérisé en ce que** le premier matériau et/ou ledit au moins un deuxième matériau à base de céramique comporte du verre photostructurable, du borosilicate, de l'aluminosilicate, du verre de quartz, du zérodur, du corindon monocristallin, du corindon polycristallin, de l'alumine, de l'oxyde d'aluminium, du nitrure d'aluminium, du rubis monocristallin, du rubis polycristallin, de l'oxyde de zirconium, de l'oxyde de titane, du nitrure de titane, du carbure de titane, du nitrure de tungstène, du carbure de tungstène, du nitrure de bore ou du carbure de bore.

8. Procédé selon l'une des revendications précédentes, **caractérisé en ce que** le premier matériau et/ou ledit au moins un deuxième matériau est formé à base de métal.

9. Procédé selon la revendication précédente, **caractérisé en ce que** le premier matériau et/ou ledit au moins un deuxième matériau à base de métal comporte un alliage de fer, un alliage de cuivre, du nickel ou un de ses alliages, du titane ou un de ses alliages, de l'or ou un de ses alliages, de l'argent ou un de ses alliages, du platine ou un de ses alliages, du ruthénium ou un de ses alliages, du rhodium ou un de ses alliages ou du palladium ou un de ses alliages.

10. Procédé de fabrication selon l'une des revendications précédentes, **caractérisé en ce que** plusieurs spiraux compensateurs composites (31, 41) sont réalisés sur le même substrat (2, 2', 12, 12', 22, 22').

**Patentansprüche**

1. Verfahren zum Herstellen einer kompensierenden Verbund-Spiralfeder (31, 41), das die folgenden Schritte umfasst:

a) Bereitstellen einer ersten Platte (1) aus einem ersten Material;

b) Bereitstellen mindestens einer zweiten Platte (3, 3') aus mindestens einem zweiten Material, dessen Veränderungen (CTE) des Young-Moduls in Abhängigkeit von der Temperatur ein entgegengesetztes Vorzeichen haben zu jenen (CTE) des ersten Materials;

c) Befestigen der ersten Platte (1) an der mindestens einen zweiten Platte (3, 3'), um ein Substrat (2, 2') zu bilden;

d) Ätzen eines Durchgangsmusters (4) in das Substrat (2), um eine kompensierende Verbund-Spiralfeder (31, 41) auszubilden, die eine erste Dicke ($E_1$) des ersten Materials und mindestens eine zweite Dicke ($E_2$, $E'_2$) des mindestens einen zweiten Materials aufweist;

e) Abtrennen der kompensierenden Verbund-Spiralfeder (31, 41) von dem Substrat (2, 2').

2. Verfahren zum Herstellen einer kompensierenden Verbund-Spiralfeder (31, 41), das die folgenden Schritte umfasst:

a) Bereitstellen einer ersten Platte (11) aus einem ersten Material;

b) Bereitstellen mindestens einer zweiten Platte (13, 13') aus mindestens einem zweiten Material, dessen Veränderungen (CTE) des Young-Moduls in Abhängigkeit von der Temperatur ein entgegengesetztes Vorzeichen haben zu jenen (CTE) des ersten Materials;

d') Ätzen gleicher Durchgangsmuster (14, 16, 16') in jede der Platten (13, 11, 13');

c') Befestigen der ersten Platte (11) an der mindestens einen zweiten Platte (13, 13'), um ein Substrat (12, 12') auszubilden und um durch Übereinanderlagerung gleicher Muster (14, 16, 16') eine kompensierende Verbund-Spiralfeder (31, 41) auszubilden, die eine erste Dicke ($E_1$) des ersten Materials und mindestens eine zweite Dicke ($E_2$, $E'_2$) des mindestens einen zweiten Materials aufweist;

e) Abtrennen der kompensierenden Verbund-Spiralfeder (31, 41) von dem Substrat (12, 12').

3. Verfahren zum Herstellen einer kompensierenden Verbund-Spiralfeder (31, 41), das die folgenden Schritte umfasst:

a) Bereitstellen einer ersten Platte (21) aus einem ersten Material;

b) Bereitstellen mindestens einer zweiten Platte (23, 23') aus mindestens einem zweiten Material, dessen Veränderungen (CTE) des Young-Moduls in Abhängigkeit von der Temperatur ein entgegengesetztes Vorzeichen haben zu jenen (CTE) des ersten Materials;

f) Ätzen gleicher Muster (24, 26, 26') in jede der Platten (23, 21, 23') in nur einem Teil der Dicke;

g) Befestigen der ersten Platte (21) an der mindestens einen zweiten Platte (23, 23'), um durch Übereinanderlagern gleicher Muster (24, 26, 26') ein Substrat (22, 22') auszubilden;

f') Ätzen der gleichen Muster (24, 26, 26') in den Rest des Substrats (22), um eine kompensierende Verbund-Spiralfeder (31, 41) auszubilden, die eine erste Dicke ($E_1$) des ersten Materials und mindestens eine zweite Dicke ($E_2$, $E'_2$) des mindestens einen zweiten Materials aufweist;

e) Abtrennen der kompensierenden Verbund-Spiralfeder (31, 41) von dem Substrat (22, 22').

4. Verfahren nach einem der vorhergehenden Ansprüche, **dadurch gekennzeichnet, dass** das erste Material und/oder das mindestens eine zweite Material auf Siliciumbasis gebildet sind.

5. Verfahren nach dem vorhergehenden Anspruch, **dadurch gekennzeichnet, dass** das erste Material und/oder das mindestens eine zweite Material auf Siliciumbasis monokristallines Silicium, dotiertes monokristallines Silicium, polykristallines Silicium, dotiertes polykristallines Silicium, poröses Silicium, Siliciumoxid, Quarz, Kieselerde, Siliciumnitrid oder Siliciumcarbid enthalten.

6. Verfahren nach einem der vorhergehenden Ansprüche, **dadurch gekennzeichnet, dass** das erste Material und/oder das mindestens eine zweite Material auf Keramikbasis gebildet sind.

7. Verfahren nach dem vorhergehenden Anspruch, **dadurch gekennzeichnet, dass** das erste Material und/oder das mindestens eine zweite Material auf Keramikbasis ein photostrukturierbares Glas, Borsilikat, Aluminosilikat, Quarzglas, Zerodur, monokristallinen Korund, polykristallinen Korund, Tonerde, Aluminiumoxid, Aluminiumnitrid, monokristallinen Rubin, polykristallinen Rubin, Zirkonoxid, Titanoxid, Titannitrid, Titancarbid, Wolframnitrid, Wolframcarbid, Bornitrid oder Borcarbid enthalten.

8. Verfahren nach einem der vorhergehenden Ansprüche, **dadurch gekennzeichnet, dass** das erste Material und/oder das zweite Material auf Metallbasis gebildet sind.

9. Verfahren nach dem vorhergehenden Anspruch, **dadurch gekennzeichnet, dass** das erste Material und/oder das mindestens eine zweite Material auf Metallbasis eine Eisenlegierung, eine Kupferlegierung, Nickel oder eine seiner Legierungen, Titan oder eine seiner Legierungen, Gold oder eine seiner Legierungen, Silber oder eine seiner Legierungen, Platin oder eine seiner Legierungen, Ruthenium oder eine seiner Legierungen, Rhodium oder eine seiner Legierungen oder Palladium oder eine seiner Legierungen enthalten.

10. Herstellungsverfahren nach einem der vorhergehenden Ansprüche, **dadurch gekennzeichnet, dass** in demselben Substrat (2, 2', 12, 12', 22, 22') mehrere kompensierende Verbund-Spiralfedern (31, 41) ausgebildet werden.

**Claims**

1. Method for manufacturing a composite compensating balance spring (31, 41) comprising the following steps:

    a) taking a first wafer (1) made of a first material;
    b) taking at least a second wafer (3, 3') made of at least a second material whose Young's modulus variations with temperature *(TEC)* are of the opposite sign to those (*TEC*) of the first material;
    c) joining the first wafer (1) to the at least one second wafer (3, 3') to form a substrate (2, 2');
    d) etching a pattern (4) through the substrate (2, 2') to form a composite compensating balance spring (31, 41) including a first thickness ($E_1$) of the first material and at least a second thickness ($E_2$, $E'_2$) of the at least second material;
    e) releasing the composite compensating balance spring (31, 41) from the substrate (2, 2').

2. Method for manufacturing a composite compensating balance spring (31, 41) comprising the following steps:

    a) taking a first wafer (11) made of a first material;
    b) taking at least a second wafer (13, 13') made of at least a second material whose Young's modulus variations with temperature (*TEC*) are of the opposite sign to those (*TEC*) of the first material;
    d') etching identical patterns (14, 16, 16') through each of the wafers (13, 11, 13');
    c') joining the first wafer (11) to the at least one second wafer (13, 13') to form a substrate (12, 12') and, by superposition of the same patterns (14, 16, 16'), and form a composite compensating balance spring (31, 41) including a first thickness ($E_1$) of the first material and at least a second thickness ($E_2$, $E'_2$) of the at least second material;
    e) releasing the composite compensating balance spring (31, 41) from the substrate (12, 12').

3. Method for manufacturing a composite compensating balance spring (31, 41) comprising the following steps:

    a) taking a first wafer (21) made of a first material;
    b) taking at least a second wafer (23, 23') made of at least a second material whose Young's modulus variations with temperature (*TEC*) are of the opposite sign to those (*TEC*) of the first material;
    f) etching identical patterns (24, 26, 26') in each of the wafers (23, 21, 23') in only one part of the thickness;
    g) joining the first wafer (21) to the at least one second wafer (23, 23') to form a substrate (22, 22') by superposition of the same patterns (24, 26, 26');
    f') etching the identical patterns (24, 26, 26') in the rest of the substrate (22, 22') to form a composite compensating balance spring (31, 41) including a first thickness ($E_1$) of the first material and at least a second thickness ($E_2$, $E'_2$) of the at least second material;
    e) releasing the composite compensating balance spring (31, 41) from the substrate (22, 22').

4. Method according to any of claims 1 to 3, **characterized in that** the first material and/or the at least one second material is silicon-based.

5. Method according to claim 4, **characterized in that** the first material and/or the at least one silicon-based second material includes single crystal silicon, doped single crystal silicon, polycrystalline silicon, doped polycrystalline silicon, porous silicon, silicon oxide, quartz, silica, silicon nitride or silicon carbide.

6. Method according to any of claims 1 to 5, **characterized in that** the first material and/or the at least one second material is ceramic-based.

7. Method according to claim 6, **characterized in that** the first material and/or the at least one ceramic-based second material includes photostructurable glass, borosilicate, aluminosilicate, quartz glass, zerodur, single crystal corundum, polycrystalline corundum, alumina, aluminium oxide, aluminium nitride, single crystal ruby, polycrystalline ruby, zirconium oxide, titanium oxide, titanium nitride, titanium carbide, tungsten nitride, tungsten carbide, boron nitride or boron carbide.

8. Method according to any of claims 1 to 7, **characterized in that** the first material and/or the at least one second material is metal-based.

9. Method according to claim 8, **characterized in that** the first material and/or the at least one metal-based second material includes an iron alloy, a copper alloy, nickel or an alloy thereof, titanium or an alloy thereof, gold or an alloy thereof, silver or an alloy thereof, platinum or an alloy thereof, ruthenium or an alloy thereof, rhodium or an alloy thereof, or palladium or an alloy thereof.

10. Manufacturing method according to any of claims 1 to 9, **characterized in that** several composite compensating balance springs (31, 41) are made on the same substrate (2, 2', 12, 12', 22, 22').

Fig. 1

Fig. 2

Fig. 3

Fig. 11

Fig. 4

Fig. 5

Fig. 6

## Fig. 7

## Fig. 8

## Fig. 9

## Fig. 10

## Fig. 12

## Fig. 13

## Fig. 18

## Fig. 14

16,26

13,23

## Fig. 15

14,24

21

## Fig. 16

16',26'

13',23'

## Fig. 17

14,16'
24,26'

41

16,26

12',22'

**EP 2 952 972 B1**

## RÉFÉRENCES CITÉES DANS LA DESCRIPTION

**Documents brevets cités dans la description**

- EP 1422436 A

- EP 1436830 A